# EUROPÄISCHE PATENTSCHRIFT

(11) **EP 3 104 528 B1**
(45) Veröffentlichungstag und Bekanntmachung des Hinweises auf die Patenterteilung: **28.08.2019**
(21) Anmeldenummer: 16173464.5
(22) Anmeldetag: 08.06.2016
(51) Int. Cl.: H03K 17/693, H03K 17/689, H03K 17/687, H03K 17/0412

(54) **BIDIREKTIONALER MOSFET-SCHALTER UND MULTIPLEXER**
BI-DIRECTIONAL MOSFET SWITCH AND MULTIPLEXER
INTERRUPTEUR MOSFET BIDIRECTIONNEL ET MULTIPLEXEUR

(30) Priorität: 10.06.2015 DE 102015109167
(43) Veröffentlichungstag der Anmeldung: 14.12.2016
(73) Patentinhaber: WEETECH GmbH, 97877 Wertheim (DE)
(72) Erfinder: Hengl, Rudi, 97877 Wertheim (DE); Reuter, Christian, 97877 Wertheim/Mohnfeld (DE)
(74) Vertreter: Gulde & Partner

(56) Entgegenhaltungen:
- WO-A1-2011/114948
- US-A- 5 138 177

## Beschreibung

Die Erfindung betrifft einen bidirektionalen MOSFET-Schalter und einen Multiplexer mit mindestens zwei bidirektionalen MOSFET-Schaltern.

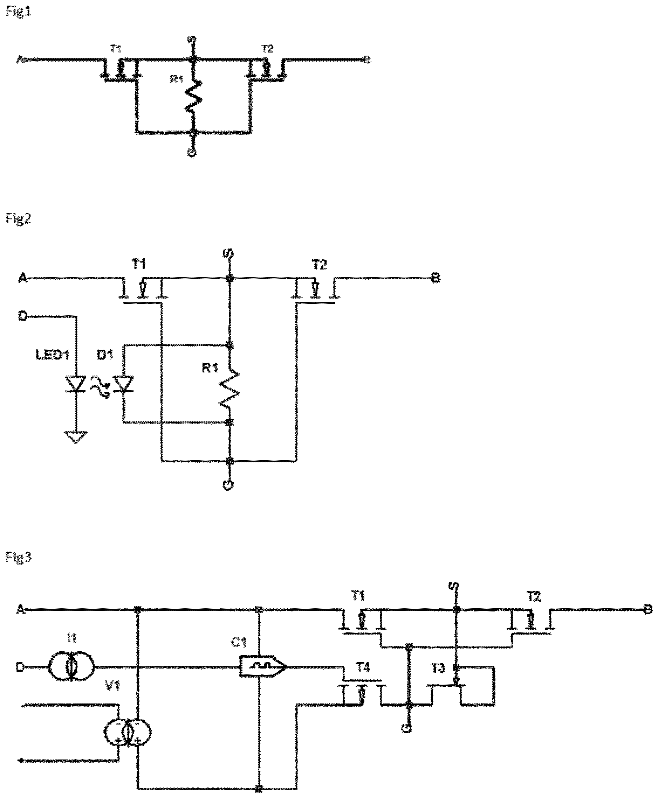

Die vorliegende Schaltungstopologie basiert auf einer bereits bekannten MOSFET-Schaltungstopologie zur bidirektionalen Signalverschaltung, welche auch als "common source" bezeichnet wird und in Figur 1 dargestellt ist.

Um die Transistoren in den leitenden Zustand zu schalten, ist ein Steuerstrom nötig, der über den Widerstand R1 die benötigte Gate-Source-Spannung erzeugt und die Eingangskapazitäten der beiden Gates von T1 und T2 lädt. Ist diese Steuerspannung galvanisch mit der Signalspannung gekoppelt, muss diese, je nach verwendeten MOSFET-Typen (N- oder P-Kanal), im Bereich der Transistorspezifikation, größer oder kleiner als die Signalspannung sein, damit T1 und T2 in den leitenden Zustand geschaltet werden können. Dies kann bei Hochspannungs-Signalen technisch schwierig sein. Nachteilig ist auch, dass sich der Steuerstrom mit dem Signalstrom überlagern kann und über die Anschlüsse A oder B zum Gegenpotential fließt. Dadurch ist diese Schaltungsvariante für eine Verschaltung von Messspannungssignalen ungünstig.

Deshalb wird hier oft der Steuerstrom photovoltaisch erzeugt (siehe Figur 2), was einerseits für die galvanische Trennung zur Ansteuerung sorgt und andererseits verhindert, dass sich der Steuerstrom mit dem Signalstrom überlagert. Nachteilig ist hierbei, dass für die Ansteuerung der Gates von T1 und T2 ein relativ großer Steuerstrom benötigt wird, der primär erst einmal die LED1 versorgen muss. Der sekundärseitig erzeugte Steuerstrom, z.B. von einer Photo-Diode (D1), ist relativ klein, was einem schnellen Einschalten von T1 und T2 entgegensteht.

Wird diese Art von Schalter mehrfach benötigt, zum Beispiel bei einer Realisierung eines Multiplexers, muss diese Art der galvanisch getrennten Ansteuerung für jedes Transistorpaar einzeln realisiert werden. Dies ist technisch aufwendig.

Es gibt in der Prüf- und Messtechnik, zum Beispiel für automatisierte Verbindungstester die Aufgabenstellung, Signalspannungen und Ströme mittels einer Schaltmatrix zu verschalten, welche aus bis zu mehreren tausend Einzelschaltern besteht und Ströme bis in den Amperebereich und Spannungen bis einige Kilovolt verschalten muss. Handelt es sich bei der Signalspannung um eine berührungsgefährliche Spannung, müssen aus Sicherheitsgründen für jede Ansteuerung die Vorgaben für Luft- und Kriechstrecken und Isolation aus der jeweils zutreffenden Sicherheits-Norm (z.B. IEC60950, IEC61010 usw.) eingehalten werden, um Ansteuerung und Schalter sicher voneinander zu trennen. Die großen Abstände, bedingt durch den gemischten Aufbau von Schaltelement einerseits und Ansteuerleitungen andererseits, welche auch von den anderen Schaltelementen der Matrix isoliert sein müssen, erschweren den Aufbau mit einer großen Packungsdichte, was den Aufbau verteuert, beziehungsweise den Aufbau größer werden lässt.

Eine weitere Variante zur galvanischen Trennung gegenüber der photovoltaischen Ansteuerung ist die kapazitive Ansteuerung, mittels zwei kleinen Kondensatoren. Diese können aber nur AC-Signale übertragen, welche dann letztlich wieder gleichgerichtet werden müssen, um die benötigte Gate-Source-Spannung für T1 und T2 zu liefern.

Weiterhin ist die aufwändige, teure Variante der Ansteuerung mittels eines Trafo bekannt. Auch hier können nur AC-Signale übertragen werden, die dann sekundärseitig gleichgerichtet werden müssen.

Durch die galvanische Trennung bei der Ansteuerung wird vermieden, dass sich der Ansteuerstrom mit dem zu verschaltenden Strom überlagert und erlaubt, dass die Ansteuerspannung ein von der Signalspannung unterschiedliches Potential haben kann. Eine technische Schwierigkeit stellt dabei die zu übertragende Energie dar, welche über die galvanische Trennung möglichst effizient übertragen werden muss, um die Gates der beiden Transistoren T1 und T2 zu laden, damit diese genügend schnell in den leitenden Zustand schalten können. Bei der gängigen Ansteuerung mittels Photovoltaik wird relativ viel Energie benötigt, um die Verluste der Koppelstrecke LED-Empfängerdiode auszugleichen, was bei einer Multiplexeranordnung mit vielen Schaltern zu großen Verlustleistungen führen würde.

Aus der WO 2011/114948 A1 ist eine elektronische Schaltvorrichtung bekannt, welche zwei miteinander in Serie verschaltete FET-Transistoren aufweist, deren Gate- und Source-Anschlüsse miteinander elektrisch leitfähig verbunden sind.

Der Erfindung liegt nun die Aufgabe zugrunde, eine bidirektionalen MOSFET-Schaltungstopologie zu verbessern.

Diese Aufgabe wird gelöst mit einem bidirektionalen MOSFET-Schalter gemäß Anspruch 1 beziehungsweise einem Multiplexer gemäß Anspruch 11.

Der erfindungsgemäße bidirektionale MOSFET-Schalter umfasst einen Eingang und einen Ausgang und zwei MOSFET-Transistoren, die mit ihren Source- und Gate-Anschlüssen miteinander verbunden sind, wobei der Eingang und der Ausgang mit jeweils einem Drain-Anschluss der zwei MOSFET-Transistoren verbunden ist. Ferner umfasst der bidirektionale MOSFET-Schalter einen mittels einer Potentialtrennung galvanisch isolierten Steuereingang, der mit einer Steuereinheit verbunden ist, welche eingerichtet ist, über einen weiteren MOSFET-Transistor einen Steuerstrom für einen Sperrschicht FET-Transistor zu schalten. Der Gate-Anschluss und der Source-Anschluss des Sperrschicht FET-Transistors sind miteinander verbunden, wobei der Gate-Anschluss des Sperrschicht FET-Transistors mit den Source-Anschlüssen der zwei MOSFET-Transistoren und der Drain-Anschluss des Sperrschicht FET-Transistors mit den Gate-Anschlüssen der zwei MOSFET-Transistoren und dem weiteren MOSFET-Transistor verbunden ist. Ferner umfasst der bidirektionale MOSFET-Schalter eine potentialfreie Spannungsquelle, welche mit dem Eingang galvanisch verbunden ist, zwischen den Eingang und den weiteren MOSFET-Transistor geschaltet ist und eingerichtet ist, den Steuerstrom zu erzeugen.

Der erfindungsgemäße bidirektionaler MOSFET-Schalter hat den Vorteil, dass auch für Wechselspannungssignale ein geringer Steuerstrom für die Schaltungstopologie ausreichend ist.

Der Sperrschicht FET-Transistor ist somit eingerichtet, den Steuerstrom durch eine Stromsättigung in eine Gate-Source-Spannung zu wandeln. Dadurch wird ein hochohmiger Zustand hervorgerufenen, um die zwei MOSFET-Transistoren einzuschalten. Dieser Steuerstrom wird von dem Sperrschicht FET-Transistor dadurch begrenzt, dass dieser in die Sättigung geht. Er stellt dann eine hochohmige Konstantstromquelle dar. So fließt ein erhöhter Einschaltstrom nur kurzfristig bis die Gates von T1 und T2 geladen sind.

Der Sperrschicht FET-Transistor ist ferner in einem nicht von einem Steuerstrom durchflossenen Zustand eingerichtet, die Gates der zwei MOSFET-Transistoren niederohmig mit der Source der zwei MOSFET-Transistoren zu verbinden, um die zwei MOSFET-Transistoren auszuschalten. Der niederohmige Widerstand des Sperrschicht FET-Transistors hat den Vorteil, dass bei Verschaltung von AC-Signalen nur entsprechend kleine RC-Glieder mit den parasitären Kapazitäten von T1 und T2 gebildet werden und so das Leckstromverhalten, verbessert wird, indem die Vgs von T1 und T2 sicherer unter der Transistor-threshold-Spannung gehalten werden kann.

Die potentialfreie Spannungsquelle oder floatende Spannungsversorgung kann mit einem der beiden Drain-Anschlüsse der zwei MOSFET-Transistoren galvanisch verbunden sein. Dies erlaubt eine einfache Realisierung der Versorgung für die Steuereinheit. Die potentialfreie Spannungsquelle kann die Sekundärseite eines DC/DC-Wandlers sein, eine Batterie oder eine Spannung, die generatorisch erzeugt wird, zum Beispiel durch einen Energie-Harvester oder eine Solarzelle.

Die potentialfreie Spannungsquelle kann die Spannungs- und/oder Strom-Versorgung für die Steuereinheit sein, was den Schaltungsaufbau vereinfacht.

Die potentialfreie Spannungsquelle kann eingerichtet sein, den Steuerstrom zu erzeugen, um den Sperrschicht FET-Transistor hochohmig zu steuern und die Gate-Kapazitäten der zwei MOSFET-Transistoren aufzuladen. So fließt ein erhöhter Einschaltstrom nur kurzfristig bis die Gates von T1 und T2 geladen sind. Die Transistoren T1 und T2 werden dadurch schneller in den leitenden Zustand geschaltet.

Die Steuereinheit kann eingerichtet sein, den Schaltzustand des weiteren MOSFET-Transistors zu speichern. Die Steuereinheit kann im einfachsten Fall ein Flip-Flop sein, welches den Schaltzustand des Analogschalters speichert. Dies erlaubt ein einfaches bidirektionales Schalten.

Der weitere MOSFET-Transistor kann eingerichtet sein, den Steuerstrom der potentialfreien Spannungsquelle in Abhängigkeit des gespeicherten Schaltzustands der Steuereinheit zu schalten. Dies erlaubt ein einfaches bidirektionales Schalten.

Die zwei MOSFET-Transistoren können N-Kanal-Typen sein und die potentialfreie Spannungsquelle kann mit ihrem negativen Potential mit dem Drain-Anschluss eines der zwei MOSFET-Transistoren verbunden sein oder die zwei MOSFET-Transistoren können P-Kanal-Typen sein und die potentialfreie Spannungsquelle kann mit ihrem positiven Potential mit dem Drain-Anschluss eines der zwei MOSFET-Transistoren verbunden sein. Auf diese Weise kann die Schaltung einfach für beide Typen von Transistoren realisiert werden.

Der weitere MOSFET-Transistor kann vom P-Kanal-Typ sein, wenn die zwei MOSFET-Transistoren N-Kanal-Typen sind oder wobei der weitere MOSFET-Transistor vom N-Kanal-Typ ist, wenn die zwei MOSFET-Transistoren P-Kanal-Typen sind. Auf diese Weise kann die Schaltung einfach für beide Typen von Transistoren realisiert werden.

Der erfindungsgemäße Multiplexer umfasst mindestens zwei bidirektionale MOSFET-Schalter wie zuvor beschrieben, wobei eine Potentialtrennung und eine potentialfreie Spannungsquelle gemeinsam für alle bidirektionalen MOSFET-Schalter vorgesehen sind. Der erfindungsgemäße Multiplexer hat den Vorteil, dass auch für Wechselspannungssignale ein geringer Steuerstrom für die Schaltungstopologie ausreichend ist, was eine hohe Skalierbarkeit bei Multiplexern, insbesondere für Schaltmatrizen erlaubt.

Die Erfindung wird nachfolgend in Ausführungsbeispielen anhand der zugehörigen Zeichnungen erläutert. Es zeigen:
- Figur 1: ein bidirektionaler MOSFET-Schalter aus dem Stand der Technik;
- Figur 2: ein bidirektionaler MOSFET-Schalter mit photovoltaisch erzeugtem Steuerstrom aus dem Stand der Technik;
- Figur 3: ein bidirektionaler MOSFET-Schalter gemäß einem Ausführungsbeispiel der Erfindung;
- Figur 4: ein Multiplexer gemäß einem Ausführungsbeispiel der Erfindung;
- Figur 5: ein bidirektionaler MOSFET-Schalter mit Schutzbeschaltung gemäß einem Ausführungsbeispiel der Erfindung; und
- Figur 6: ein bidirektionaler MOSFET-Schalter mit komplementären Transistoren im Vergleich zu Figur 3 gemäß einem Ausführungsbeispiel der Erfindung.

Figur 3 zeigt ein erstes Ausführungsbeispiel eines bidirektionaler MOSFET-Schalters beziehungsweise einer Schaltungstopologie bestehend aus zwei MOSFET Transistoren T1 und T2. Die beiden MOSFET Transistoren T1 und T2 sind mit ihren Source-Anschlüssen S und Gate-Anschlüssen G miteinander verbunden sind und stellen gewissermaßen das eigentliche bidirektionale Schaltelement dar. Der sonst übliche Gate-Source-Widerstand ist durch einen Sperrschicht FET-Transistor T3 mit niedriger "pinch off" Spannung ersetzt. Der Sperrschicht FET-Transistor T3 ist mit seinem Gate-Anschluss und seinem Source-Anschluss mit der Source der beiden MOSFET Transistoren T1 und T2 verbunden. Der Drain-Anschluss ist mit dem Gate der beiden MOSFET Transistoren T1 und T2 verbunden.

Fließ kein Ansteuerstrom, stellt der Sperrschicht FET-Transistor T3 eine relativ niederohmige Verbindung dar, welche die Gate- mit den Source-Anschlüssen von T1 und T2 verbindet. So werden die Gates entladen und die beiden Transistoren T1 und T2 in den nichtleitenden Zustand geschaltet. Ein sonst verwendeter hochohmiger Widerstand, um den Steuerstrom klein zu halten, würde bei Verschaltung von AC-Signalen ein Nachteil darstellen, da er ein RC-Glied mit den parasitären Kapazitäten von T1 und T2 bildet. Dies würde das Leckstromverhalten von T1 und T2 nachteilig beeinflussen, indem bei schnellen Potentialverschiebungen an S das Potential an G nicht mehr mit S ausgeglichen werden kann. Dies könnte dazu führen, dass T1 und T2 durch die entstehende Spannung Vgs eventuell schon etwas leitend werden. Des Weiteren führt ein hochohmiger Widerstand zu langsameren Ausschaltzeiten von T1 und T2.

Die oben genannten Nachteile werden durch die Verwendung des Sperrschicht FET-Transistors T3 vermieden. Es kann je nach Polarität der Signalspannung vorkommen, dass zwar eine der beiden "body" Dioden von T1 oder T2 leitet, aber es ist auch immer einer der beiden Transistoren T1 oder T2 in Sperrrichtung geschaltet, was dafür sorgt, dass sich der Schalter polaritätsunabhängig im nichtleitenden Zustand befindet.

Die erfindungsgemäße Schaltungstopologie besteht weiterhin aus einem weiteren Schaltungsteil, um die beiden Transistoren T1 und T2 in den leitenden Zustand zu schalten. Eine "floatende" Spannungsversorgungsquelle V1 ist sekundärseitig mit einem Eingang A der Schaltung galvanisch verbunden. Diese stellt die Versorgung für eine Steuereinheit oder Ansteuerung C1, welche im einfachsten Fall ein Flip-Flop als Schaltzustandsspeicher ist, dar. An den Eingang A ist weiterhin der Drain-Anschluss des Transistors T1 angeschlossen. Der Drain-Anschluss des Transistors T2 ist mit einem Ausgang B der Schaltung verbunden.

Der Eingang der Steuereinheit C1 ist mit einer Ansteuerleitung oder einem Ansteuerbus D der Schaltung verbunden, in der eine Potentialtrennung I1 vorgesehen ist. Der Ausgang der Steuereinheit C1 steuert einen weiteren MOSFET Schalttransistor T4 an. Handelt es sich bei D um einen Ansteuerbus, wird in der Steuereinheit C1 auch die Dekodierung des Ansteuersignals für T4 vorgenommen. Ist T4 leitend geschaltet, treibt die Quelle V1 einen Steuerstrom über T4 zum FET T3. Dieser Steuerstrom wird von dem FET T3 dadurch begrenzt, dass dieser in die Sättigung geht und dann eine hochohmige Konstantstromquelle darstellt. Es fließt dadurch im Einschaltmoment bis die Gates von T1 und T2 geladen sind nur kurzfristig ein größerer Einschaltstrom als der Konstantstrom der sich durch den FET T3 einstellt. Die Potentialtrennung I1 sorgt dafür, dass der Steuerstrom nur im Kreis V1, T4, T3, und T1 fließt.

Die Transistoren T1 und T2 werden dadurch schneller in den leitenden Zustand geschaltet. Dies und der kontrolliert begrenzte Ansteuerstrom stellt einen Vorteil dieser Schaltung dar, um die Steuerstromverlustleistung und die Schaltverlustleistung von T1 und T2 klein zu halten. Über die "body" Diode von T1 kann der Steuerstrom auch im ausgeschalteten Zustand von T1 immer zur Quelle V1 zurückfließen, wodurch sich T1 und T2 immer durch den Steuerstrom ansteuern lassen, unabhängig vom Potential an S. Ein weiterer Vorteil dieser Schaltungstopologie ist die Tatsache, dass der Steuerstrom von der floatenden Quelle V1 nur im Kreis V1, T4, T3, und T1 fließen kann und nicht über die Anschlüsse A oder B fließen kann und sich somit, außerhalb der Anschlüsse A und B, nicht mit dem Signalstrom überlagert.

Alle Bauteile in diesen genannten Schaltungskreisen müssen im Hinblick auf die Signalspannungshöhe nur eine ausreichend hohe Funktionsisolierung besitzen, die bedeutend einfacher zu realisieren ist, als eine sicherheitsrelevante Isolierung zu den Ansteuerleitungen für berührungsgefährliche Spannungen. In Figur 3 sind die Transistoren T1 und T2 als normal sperrende N-Kanal MOSFET Transistoren ausgeführt, während der Transistor T4 als normal sperrende P-Kanal MOSFET Transistor ausgeführt ist.

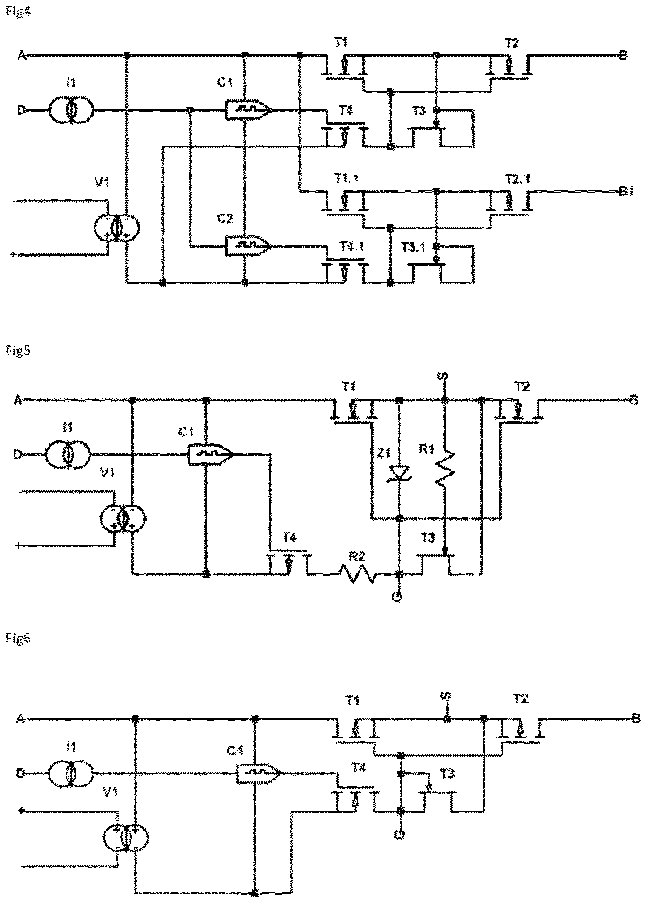

In Figur 4 ist eine Schaltungstopologie als Multiplexer dargestellt, hier als 1:2 Multiplexer. Entsprechend sind zwei bidirektionale MOSFET-Schalter aus Figur 3 vorgesehen, die parallel mit dem Eingang A verbunden sind und zwei Ausgänge B und B1 erzeugen.

Vorteilhafterweise ist die Potentialtrennung I1 zentral für beide Ansteuerungen C1 und C2 und für die Spannungsquelle V1, zum Beispiel ein DC/DC-Wandler, realisiert. Dies stellt eine bedeutende technische Vereinfachung im Hinblick auf den Anspruch von Luft- und Kriechstrecken, Isolation, Bauteilanzahl und Packungsdichte dar. Dies ist insbesondere der Fall für Multiplexer mit einer großen Anzahl von Einzelschaltern wie zum Beispiel 1:1000 Multiplexer.

Die Ansteuerleitung D und die Versorgungsspannung V1 können zentral außerhalb des Bereiches einer Platine, getrennt vom Bereich der Verschaltung der Signalspannung, von der Signalspannung isoliert werden. Innerhalb des "Schaltbereichs" haben sie durch die galvanische Kopplung mit Anschluss A das gleiche, bzw. nur ein durch die sekundärseitige Spannung von V1 unterschiedliches Potential zur Signalspannung an A, wodurch die Isolationsanforderungen gegenüber A nur sehr gering sind. Dies erhöht die Packungsdichte einer solchen Schaltmatrix, beziehungsweise macht sie funktionell sicherer, da es zu keinen Spannungsüberschlägen vom Potential an Azur Ansteuerelektronik C kommen kann.

Für die Ansteuerung der Schaltung an D wird nur eine geringe Leistung benötigt, da diese nicht mehr direkt die Gates von T1 und T2 ansteuern muss. Dadurch wird die technische Ausführung vereinfacht und die Ansteuerleistung kann reduziert werden.

Die Potentialtrennung I1 sorgt dafür, dass der Steuerstrom nur im Kreis V1, T4, T3, und T1 fließt. Dadurch, dass die Potentialtrennung in einer Multiplexeranordnung nicht für jeden einzelnen Schalter gebraucht wird (im Extremfall nur einmal pro Multiplexer) und die Signalleistung gering ist, da das Ansteuersignal an D nur hochohmige Eingänge treiben muss, wirken sich die Verluste durch die Potentialtrennung weniger stark aus.

Die erfindungsgemäße Schaltungstopologie kann einfach um die üblichen Schutzbeschaltungen von strombegrenzenden Widerständen und spannungsbegrenzenden Dioden ergänzt werden, wie in Figur 5 dargestellt ist. Derartige Beschaltungen können auch im Multiplexer gemäß Figur 4 verwendet werden. Im Einzelnen ist eine Zenerdiode Z1 zwischen Source S und Gate G geschaltet, sowie ein Widerstand R1 zwischen Source und FET T3 sowie ein Widerstand R2 zwischen dem weiteren MOSFET T4 und dem FET T3 beziehungsweise Gate G.

Die erfindungsgemäße Schaltungstopologie kann mit handelsüblichen, N- oder P-Kanal MOSFET Transistoren als Schalttransistoren T1 und T2 aufgebaut werden, dabei kann es sich auch um Leistungs- bzw. Hochspannungstransistoren oder HF-Transistoren handeln. In Figur 6 ist ein im Vergleich zu Figur 3 komplementäre Transistorwahl dargestellt. Derartige Beschaltungen können auch im Multiplexer gemäß Figur 4 verwendet werden.

## Patentansprüche

1. Bidirektionaler MOSFET-Schalter, aufweisend
einen Eingang (A) und
einen Ausgang (B) und
zwei MOSFET-Transistoren (T1, T2), die mit ihren Source- und Gate-Anschlüssen miteinander verbunden sind, wobei der Eingang (A) und der Ausgang (B) mit jeweils einem Drain-Anschluss der zwei MOSFET-Transistoren (T1, T2) verbunden ist,
einen mittels einer Potentialtrennung (I1) galvanisch isolierten Steuereingang (D), der mit einer Steuereinheit (C1) verbunden ist, welche eingerichtet ist, über einen weiteren MOSFET-Transistor (T4) einen Steuerstrom für einen Sperrschicht FET-Transistor (T3) zu schalten,
**dadurch gekennzeichnet, dass**
der Gate-Anschluss und der Source-Anschluss des Sperrschicht FET-Transistors (T3) miteinander verbunden sind, wobei der Gate-Anschluss des Sperrschicht FET-Transistors (T3) mit den Source-Anschlüssen der zwei MOSFET-Transistoren (T1, T2) und der Drain-Anschluss des Sperrschicht FET-Transistors (T3) mit den Gate-Anschlüssen der zwei MOSFET-Transistoren (T1, T2) und dem weiteren MOSFET-Transistor (T4) verbunden ist, und wobei der bidirektionale MOSFET-Schalter ferner eine potentialfreie Spannungsquelle (V1) aufweist, welche mit dem Eingang (A) galvanisch verbunden ist, zwischen den Eingang und den weiteren MOSFET-Transistor geschaltet ist und eingerichtet ist, den Steuerstrom zu erzeugen.

2. Bidirektionaler MOSFET-Schalter nach Anspruch 1, wobei die potentialfreie Spannungsquelle (V1) mit einem der beiden Drain-Anschlüsse der zwei MOSFET-Transistoren (T1, T2) galvanisch verbunden ist.

3. Bidirektionaler MOSFET-Schalter nach einem der vorhergehenden Ansprüche, wobei die potentialfreie Spannungsquelle (V1) die Spannungs- und/oder Strom-Versorgung für die Steuereinheit (C1) ist.

4. Bidirektionaler MOSFET-Schalter nach einem der vorhergehenden Ansprüche, wobei die potentialfreie Spannungsquelle (V1) eingerichtet ist, den Steuerstrom zu erzeugen, um den Sperrschicht FET-Transistor (T3) hochohmig zu steuern und die Gate-Kapazitäten der zwei MOSFET-Transistoren (T1, T2) aufzuladen.

5. Bidirektionaler MOSFET-Schalter nach einem der vorhergehenden Ansprüche, wobei die Steuereinheit (C1) eingerichtet ist, den Schaltzustand des weiteren MOSFET-Transistors (T4) zu dekodieren und zu speichern.

6. Bidirektionaler MOSFET-Schalter nach einem der vorhergehenden Ansprüche, wobei der weitere MOSFET-Transistor (T4) eingerichtet ist, den Steuerstrom der potentialfreien Spannungsquelle (V1) in Abhängigkeit des gespeicherten Schaltzustands der Steuereinheit (C1) zu schalten.

7. Bidirektionaler MOSFET-Schalter nach einem der vorhergehenden Ansprüche, wobei die zwei MOSFET-Transistoren (T1, T2) N-Kanal-Typen sind und die potentialfreie Spannungsquelle (V1) mit ihrem negativen Potential mit dem Drain-Anschluss eines der zwei MOSFET-Transistoren (T1, T2) verbunden ist oder wobei die zwei MOSFET-Transistoren (T1, T2) P-Kanal-Typen sind und die potentialfreie Spannungsquelle (V1) mit ihrem positiven Potential mit dem Drain-Anschluss eines der zwei MOSFET-Transistoren (T1, T2) verbunden ist.

8. Bidirektionaler MOSFET-Schalter nach einem der vorhergehenden Ansprüche, wobei der weitere MOSFET-Transistor (T4) vom P-Kanal-Typ ist, wenn die zwei MOSFET-Transistoren (T1, T2) N-Kanal-Typen sind oder wobei der weitere MOSFET-Transistor (T4) vom N-Kanal-Typ ist, wenn die zwei MOSFET-Transistoren (T1, T2) P-Kanal-Typen sind.

9. Multiplexer mit mindestens zwei bidirektionalen MOSFET-Schaltern nach einem der vorhergehenden Ansprüche, wobei eine Potentialtrennung (I1) und eine potentialfreie Spannungsquelle (V1) gemeinsam für alle bidirektionalen MOSFET-Schalter vorgesehen sind.

## Claims

1. Bi-directional MOSFET switch comprising
an input (A) and
an output (B) and
two MOSFET transistors (T1, T2) interconnected by their source and gate terminals, the input (A) and the output (B) each being connected to a drain terminal of the two MOSFET transistors (T1, T2),
a control input (D) which is galvanically isolated by means of a potential separation (11) and is connected to a control unit (C1) which is configured to switch a control current for a junction FET transistor (T3) by means of a further MOSFET transistor (T4),
**characterized in that**
the gate terminal and the source terminal of the junction FET transistor (T3) are interconnected, wherein the gate terminal of the junction FET transistor (T3) is connected to the source terminals of the two MOSFET transistors (T1, T2) and the drain terminal of the junction FET transistor (T3) is connected to the gate terminals of the two MOSFET transistors (T1, T2) and to the further MOSFET transistor (T4),
and wherein the bi-directional MOSFET switch further comprises a floating voltage source (V1) which is galvanically connected to the input (A), is connected between the input and the further MOSFET transistor, and is configured to generate the control current.

2. The bi-directional MOSFET switch according to claim 1, wherein the floating voltage source (V1) is galvanically connected to one of the two drain terminals of the two MOSFET transistors (T1, T2).

3. The bi-directional MOSFET switch according to any one of the preceding claims, wherein the potential-free voltage source (V1) is the voltage and/or current supply for the control unit (C1).

4. The bi-directional MOSFET switch according to any one of the preceding claims, wherein the floating voltage source (V1) is configured to generate the control current in order to control the junction FET transistor (T3) with high impedance and to charge the gate capacitances of the two MOSFET transistors (T1, T2).

5. The bi-directional MOSFET switch according to any one of the preceding claims, wherein the control unit (C1) is configured to decode and store the switching state of the further MOSFET transistor (T4).

6. The bi-directional MOSFET switch according to any one of the preceding claims, wherein the further MOSFET transistor (T4) is configured to switch the control current of the floating voltage source (V1) as a function of the stored switching state of the control unit (C1).

7. The bi-directional MOSFET switch according to any one of the preceding claims, wherein the two MOSFET transistors (T1, T2) are N-channel types and the negative potential of the floating voltage source (V1) is connected to the drain terminal of one of the two MOSFET transistors (T1, T2), or wherein the two MOSFET transistors (T1, T2) are P-channel types and the positive potential of the floating voltage source (V1) is connected to the drain terminal of one of the two MOSFET transistors (T1, T2).

8. The bi-directional MOSFET switch according to any one of the preceding claims, wherein the further MOSFET transistor (T4) is of the P-channel type if the two MOSFET transistors (T1, T2) are N-channel types, or wherein the further MOSFET transistor (T4) is of the N-channel type if the two MOSFET transistors (T1, T2) are P-channel types.

9. A multiplexer including at least two bi-directional MOSFET switches according to any one of the preceding claims, wherein a potential separation (11) and a floating voltage source (V1) are provided jointly for all bi-directional MOSFET switches.

## Revendications

1. Interrupteur MOSFET bidirectionnel, comprenant
une entrée (A) et
une sortie (B) et
deux transistors MOSFET (T1, T2), lesquels sont reliés entre eux par leurs bornes de source et de grille, l'entrée (A) et la sortie (B) étant reliées à respectivement une borne de drain des deux transistors MOSFET (T1, T2), une entrée de commande (D) isolée galvaniquement au moyen d'une séparation de potentiel (11), laquelle est reliée à une unité de commande (C1), laquelle est configurée pour commuter un courant de commande pour un transistor FET à jonction (T3) par un autre transistor MOSFET (T4), **caractérisé en ce que**
la borne de grille et la borne de source du transistor FET à jonction (T3) sont reliées entre elles, la borne de grille du transistor FET à jonction (T3) étant reliée aux bornes de source des deux transistors MOSFET (T1, T2), et la borne de drain du transistor FET à jonction (T3) étant reliée aux bornes de grille des deux transistors MOSFET (T1, T2) et de l'autre transistor MOSFET (T4),
et l'interrupteur MOSFET bidirectionnel comprenant en outre une source de tension sans potentiel (V1), laquelle est reliée de façon galvanique à l'entrée (A), connectée entre l'entrée et l'autre transistor MOSFET et configurée pour générer le courant de commande.

2. Interrupteur MOSFET bidirectionnel selon la revendication 1, la source de tension sans potentiel (V1) étant reliée de façon galvanique à l'une des deux bornes de drain des deux transistors MOSFET (T1, T2).

3. Interrupteur MOSFET bidirectionnel selon l'une quelconque des revendications précédentes, la source de tension sans potentiel (V1) étant l'alimentation en tension et/ou en courant pour l'unité de commande (C1).

4. Interrupteur MOSFET bidirectionnel selon l'une quelconque des revendications précédentes, la source de tension sans potentiel (V1) étant configurée pour générer le courant de commande afin de commander le transistor FET à jonction (T3) avec une haute impédance et pour charger les capacités de grille des deux transistors MOSFET (T1, T2).

5. Interrupteur MOSFET bidirectionnel selon l'une quelconque des revendications précédentes, l'unité de commande (C1) étant configurée pour décoder et enregistrer l'état de commutation de l'autre transistor MOSFET (T4).

6. Interrupteur MOSFET bidirectionnel selon l'une quelconque des revendications précédentes, l'autre transistor MOSFET (T4) étant configuré pour commuter le courant de commande de la source de tension sans potentiel (V1) en fonction de l'état de commutation enregistré de l'unité de commande (C1).

7. Interrupteur MOSFET bidirectionnel selon l'une quelconque des revendications précédentes, les deux transistors MOSFET (T1, T2) étant avec canal de type N et la source de tension sans potentiel (V1) étant connectée par son potentiel négatif à la borne de grille de l'un des deux transistors MOSFET (T1, T2), ou les deux transistors MOSFET (T1, T2) étant avec canal de type P et la source de tension sans potentiel (V1) étant connectée par son potentiel positif à la borne de grille de l'un des deux transistors MOSFET (T1, T2).

8. Interrupteur MOSFET bidirectionnel selon l'une quelconque des revendications précédentes, l'autre transistor MOSFET (T4) étant avec canal de type P lorsque les deux transistors MOSFET (T1, T2) sont avec canal de type N, ou l'autre transistor MOSFET (T4) étant avec canal de type N lorsque les deux transistors MOSFET (T1, T2) sont avec canal de type P.

9. Multiplexeur avec au moins deux interrupteurs MOSFET bidirectionnels selon l'une quelconque des revendications précédentes, une séparation de potentiel (I1) et une source de tension sans potentiel (V1) étant prévues conjointement pour tous les interrupteurs MOSFET bidirectionnels.
